Europäisches Patentamt

European Patent Office

Office européen des brevets

(19)

(11) Publication number: **0 189 594 B1**

# EUROPEAN PATENT SPECIFICATION

(12)

(45) Date of publication of patent specification: **12.08.92**  (51) Int. Cl.⁵: **G11C 8/00**, G11C 16/04, G11C 16/06

(21) Application number: **85116579.5**

(22) Date of filing: **27.12.85**

(54) **Non-volatile semiconductor memory device.**

(30) Priority: **28.12.84 JP 277436/84**

(43) Date of publication of application:
**06.08.86 Bulletin 86/32**

(45) Publication of the grant of the patent:
**12.08.92 Bulletin 92/33**

(84) Designated Contracting States:
**DE FR GB**

(56) References cited:
**GB-A- 2 099 650**
**US-A- 3 909 808**

**IBM TECHNICAL DISCLOSURE BULLETIN, vol. 20, no. 11A, April 1978, pages 4421-4422, New York, US; J. PERRIS et al.: "Memory word driver"**

(73) Proprietor: **NEC CORPORATION**
**7-1, Shiba 5-chome Minato-ku**
**Tokyo 108-01(JP)**

(72) Inventor: **Kobatake, Hiroyuki**
**c/o NEC Corporation 7-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**W-8000 München 26(DE)**

**Description**

BACKGROUND OF THE INVENTION

Field of the Invention

The present invention relates to a non-volatile semiconductor memory device, and more particularly to a data write circuit employing a high write voltage in the non-volatile semiconductor memory device.

Description of the Prior Art

The electrically programmable, non-volatile read-only memory (referred to as an EPROM) has a plurality of memory cells arranged in a matrix of word lines and digit lines, and a data is written into a selected memory cell by applying a high voltage thereto through a selected work line or a selected digit line. The high voltage is required to be applied to the selected word line or digit line only, and all the other non-selected word lines or digit lanes are grounded or clamped at a fixed low potential. This brings about a large amount of current wastefully flowing through all the non-selected word or digit lines to the ground or the fixed potential source during data writing operation period. Such a large power consumption is one of short comings of the prior art EPROM.

Since the large amount of current flows from a terminal to which the high voltage is supplied toward the ground or the low potential source, the voltage level at the high voltage terminal is dropped down. On the other hand, a level of a high voltage enough to write a data to the respective memory cells is not constant because of deviation of a semiconductor fabrication. Accordingly, the dropped high voltage sometimes fails to write a correct data to some memory cells. This is another drawback of the conventional EPROM. This drawback may be resolved by providing the memory chip with a plurality of high voltage terminals to enable the application of the high voltage to the selected word or digit line. However, this is not practical, because the number of terminals is limited on the memory chip and it is impossible to assign many terminals for supplying a high voltage.

SUMMARY OF THE INVENTION

An object of the present invention is to provide a semiconductor memory in which wasteful current flowing through the non-selected word or digit lines from a high voltage terminal is suppressed.

Another object of the present invention is to provide a semiconductor memory in which a level at a high voltage terminal is not dropped down.

Still another object of the present invention is to provide a semiconductor memory having a write-control circuit by which a correct data can be written into a selected memory cell with a high reliability.

A semiconductor memory according to the present invention is set forth in claim 1.

According to the present invention, only one row line to which a memory cell designated by the address input signal is connected is coupled to the high voltage terminal via only one turned-on switching circuit, while all the other row lines are electrically cut off from the high voltage terminal because the other switching circuits are turned off. Therefore, no current flows through the non-selected row lines. Thus, power consumption is remarkably reduced in a data writing operation, and therefore, a voltage level at the high voltage terminal is not dropped down. As the result, correct data is written into any memory cell with a high reliability.

According to one embodiment of the present invention, each switching circuit has a plurality of enhancement type transistors equal in number to bits of address used to select one of row lines and a plurality of depletion type transistors equal in number to the enhancement type transistors. These enhancement type transistors and depletion type transistors are serially coupled each other according to a pre-determined order and are inserted between a row line and the high voltage terminal. Further, true signals and complementary signals of the address bits are applied to each transistor. That is, the switching circuit is worked as a writing decoder responsible to a writing address. Therefore, an EPROM of the present invention has both a reading decoder and a writing decoder in one semiconductor chip. The reading decoder is coupled to one end of a row line and the writing decoder is coupled between the other end of the row line and the high voltage terminal.

As described above, each switching circuit can be constructed by a serially coupled transistors, so that it can be formed in each memory cell pitch (span) of a conventional EPROM. Therefore, in the present invention, the switching circuits can be provided without extending each memory cell span, so that a memory capacity of a memory array is not reduced.

Furthermore, a gate circuit may be inserted between a row line and a switching circuit to electrically discouple the switching circuit from the row line in a data reading operation. In this case the gate circuit is turned off in response to a read control signal in a data read operation to electrically separate the row line from the switching circuit. Thus, in the read operation, the row line connected to a memory cell from which a data is read out is discoupled from the respective switching circuit. That is, a stray capacitance added to the switching circuit is electrically cut off from the row line. As the result, the memory cell connected to the row line is activated at a high speed in response to an address, so that the data can be read out of the memory cell at a high speed.

BRIEF DESCRIPTION OF THE DRAWINGS

Fig. 1 shows a block diagram of a prior art EPROM;

Fig. 2 shows a circuit diagram of a writing circuit according to an embodiment of the present invention;

Fig. 3 shows a circuit diagram of a switching circuit according to another embodiment of the present invention;

Fig. 4 shows a block diagram indicating a layout pattern of a principal part of an EPROM to which the present invention is applied;

Fig. 5 shows a circuit diagram of an X-decoder shown in Fig. 4;

Fig. 6 shows a circuit diagram of a writing circuit corresponding to three word lines of the present invention;

Fig. 7 shows a diagram indicating a plain pattern view of Fig. 6;

Figs. 8 (a), (b) and (c) show cross-sectional views of X-X' line in each fabrication process order;

Fig. 9 shows a switching circuit diagram of still another embodiment of the present invention; and

Fig. 10 shows (a) a circuit diagram of a writing circuit receiving three bits of address, (b) a equivalent circuit of (a), and (c) a plain view on a semiconductor chip.

DETAILED DESCRIPTION OF THE PREFERRED EMBODIMENTS

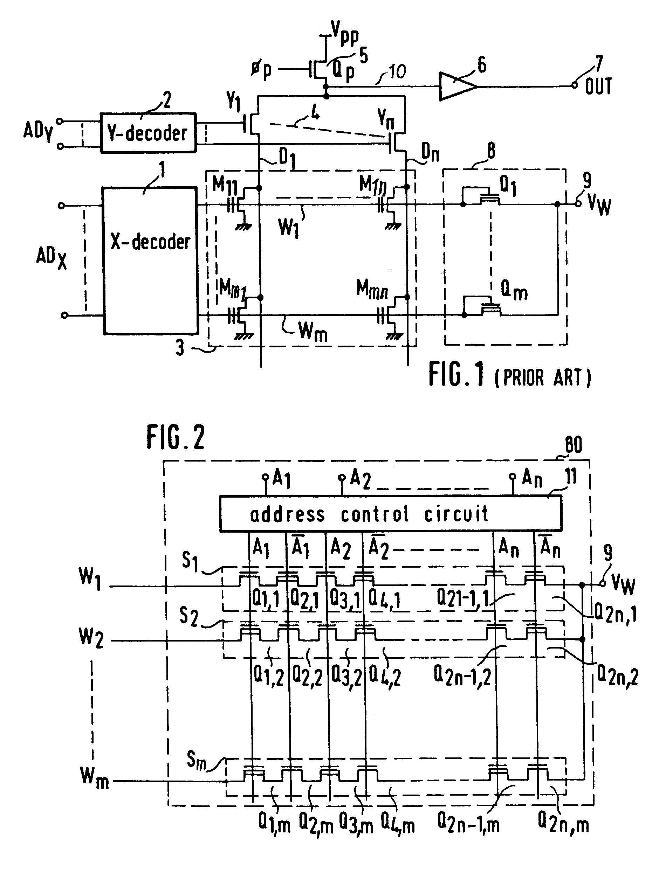

Referring to Fig. 1, a conventional EPROM will be explained in the following. The EPROM includes an X-decoder receiving a part ($AD_X$) of an address, a Y-decoder receiving the other part ($AD_Y$) of the address, a memory cell array 3 having a plurality of memory cells ($M_{11}$ to $M_{nm}$) arranged in a matrix shape, a Y-selector 4, a writing circuit 8 connected to a high voltage terminal $V_W$ 9, a precharge transistor Qp 5 and a sense amplifier 6 coupled to a data output terminal 7. Each output ends of the X-decoder is coupled to the respective word lines $W_1$ to $W_m$, so that one word line is selected according an address $AD_X$. In a data read operation, a plurality of data stored in a plurality memory cells ($M_{il}$ to $M_{im}$) connected to a selected word line $W_i$ are simultaneously read out to the respective digit lines $D_1$ to $D_n$. One of the read-out data is selected by the Y-selector 4 according to an output of the Y-decoder 2. The selected data is taken out from the output terminal 7 via the sense Amplifier 6. Before data are read out of the memory cells, a node 10 connected to the sense amplifier 6 is preliminarily precharged at Vpp through the precharge transistor Qp 5 responsive to a precharge control signal $\phi_p$.

In the conventional EPROM, when a data is written into a memory cell (e.g. $M_{11}$), an address designating the memory cell $M_{11}$ is applied to the X-decoder 1 and Y-decoder 2. The X-decoder 1 electrically disconnect only one word line $W_1$ from ground (GND) and couples all word lines $W_2$ to $W_m$ except for $W_1$ to ground (GND). On the other hand the Y-decoder 2 selects the transistor $Y_1$ connected to the digit line $D_1$ according to the address $AD_Y$, so that a predetermined voltage is supplied to the drain electrode of the memory cell $M_{11}$ through the transistor $Y_1$. Thus, a high voltage at the terminal $V_W$ 9 is supplied to the control gate of the designated memory cell $M_{11}$ through a high impedance load transistor $Q_1$ and the word line $W_1$ discoupled from the ground, and a data is written thereinto. The written data can be erased by applying ultra-violet rays in this EPROM.

According to the conventional EPROM, all of the non-selected word lines are connected to the ground, so that a plurality of electrical paths through the non-selected word lines $W_2$ to $W_m$ from the terminal $V_W$ 9 to the ground are formed. As the result, a large amount of power is consumed. Furthermore, a voltage level at the terminal drops down resulting from the current flowing through the electrical paths. Therefore, the conventional EPROM has shortcomings that a correct data can not be written into some memory cells which requires a high voltage without dropping to write a data therein.

Fig. 2 shows a circuit diagram of a writing circuit according to an embodiment of the present invention. The writing circuit 80 shown in Fig. 2 can be replaced to the writing circuit 8 of Fig. 1. The writing circuit 80

has switching circuits $S_1$ to $S_m$ equal in number to the word lines $W_1$ to $W_m$ and an address control circuit 11. The address control circuit 11 receives the address $AD_X$ ($A_1$ to $A_n$) to be applied to the X-decoder 1 and produces true signals $A_1$ to $A_n$ and complementary signals $\overline{A}_1$ to $\overline{A}_n$ which are inverted signals $A_1$ to $A_n$. Each switching circuits $S_1$ to $S_m$ includes n enhancement type P-channel MOS FETs (referred to E-PFET) and n depletion type P-channel MOS FETs (referred to D-PFET) which are connected in series according to a predetermined order as described hereinafter. In Fig. 2, $Q_{1.1}$, $Q_{3.1}$, $Q_{2.2}$ and the like are E-PFET, while $Q_{2.1}$, $Q_{4.1}$, $Q_{1.2}$ and the like are D-PFET. The true output lines $A_1$, $A_2$, ... $A_n$ and the complementary output iines $\overline{A}_1$, $\overline{A}_2$, ... $\overline{A}_n$ are alternately wired.

Now, Table 1 shows an arrangement of E-PFETs and D-PFETs in each switching circuit when 4-bit address $A_1$ to $\overline{A}_4$ are employed.

TABLE 1

|  | $A_1$ | $\overline{A}_1$ | $A_2$ | $\overline{A}_2$ | $A_3$ | $\overline{A}_3$ | $A_4$ | $\overline{A}_4$ |
|---|---|---|---|---|---|---|---|---|
| $W_1$ | E | D | E | D | E | D | E | D |
| $W_2$ | D | E | E | D | E | D | E | D |
| $W_3$ | E | D | D | E | E | D | E | D |
| $W_4$ | D | E | D | E | E | D | E | D |
| $W_5$ | E | D | E | D | D | E | E | D |
| $W_6$ | D | E | E | D | D | E | E | D |
| $W_7$ | E | D | D | E | D | E | E | D |
| $W_8$ | D | E | D | E | D | E | E | D |
| $W_9$ | E | D | E | D | E | D | D | E |
| $W_{10}$ | D | E | E | D | E | D | D | E |
| $W_{11}$ | E | D | D | E | E | D | D | E |
| $W_{12}$ | D | E | D | E | E | D | D | E |
| $W_{13}$ | E | D | E | D | D | E | D | E |
| $W_{14}$ | D | E | E | D | D | E | D | E |
| $W_{15}$ | E | D | D | E | D | E | D | E |
| $W_{16}$ | D | E | D | E | D | E | D | E |

E-PFETs and D-PFETs are arranged according to an example of Table 1 in each switching circuit. Thus, only one switching circuit is turned on, while the other are all turned off. That is, all FETs in a switching circuit corresponding to a word line selected by an address are turned on, while at least one FET in the other switching circuits is turned off. Therefore, the high voltage terminal $V_W$ 9 is coupled to the selected word line only and are discoupled to all non-selected word lines. As the result, the current paths of the conventional EPROM are not formed in the embodiment. Therefore, power consumption can be remarkably reduced. In addition, since the voltage level at the terminal $V_W$ 9 does not drop down, correct data can be written into all memory cells.

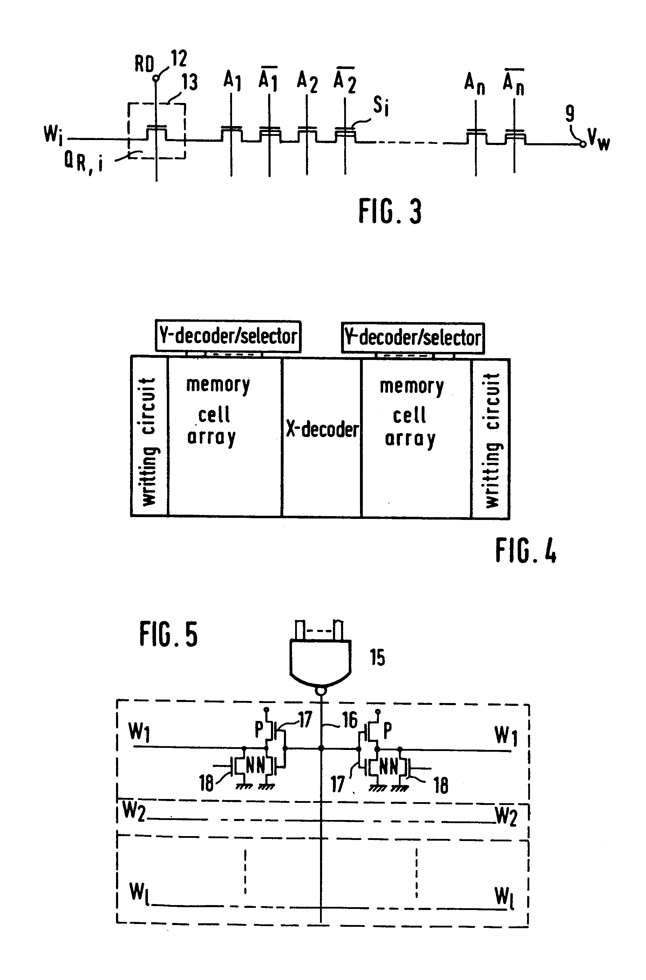

Fig. 3 shows a circuit diagram of a switching circuit according to another embodiment of the present invention. In this embodiment, a gate circuit 13 having an E-PFET $Q_{Ri}$ is inserted between the word line $W_i$ and the switching circuit $S_i$. The E-PFET $Q_{Ri}$ is controlled by a read control signal RD applied to a read control terminal 12. The read control signal is activated in a data read operation and is applied to a gate electrode of the E-PFET $Q_{Ri}$. Thus, the E-PFET $Q_{Ri}$ is turned off, so that the word line $W_i$ is electrically separated from the switching circuit $S_i$. Therefore, since a stray capacitance added to the switching circuit $S_i$ is discoupled from the word line $W_i$, a read operation speed is not showed down. For a plurality of word lines $W_1$ to $W_m$, a plurality of gate circuits 13 must be inserted between each word line and the respective switching circuits, respectively. Of cause, the gate circuit 13 is turned on in the data write operation.

Fig. 4 shows a block diagram indicating a layout pattern on an EPROM chip wherein the present invention is applied. Two memory cell arrays are provided both sides of an X-decoder and two Y-decoder and selectors are coupled to two memory cell arrays, respectively. Two writing circuit shown in Fig. 2 are used and are coupled to memory cell arrays, respectively.

Fig. 5 shows a circuit diagram of the X-decoder of Fig. 4. An NAND gate 15 receives a plurality of upper address bits and generates a select signal to an output line 16 commonly coupled to ℓ blocks of memory cell arrays. Each block has a CMOS circuit 17 consisting of a P-channel FET and an N-channel FET and an N-channel discharge FET 18. Lower address bits are applied to the N-channel discharge FET 18. In this case, ℓ word line pairs $W_l$ to $W\ell$ are simultaneously selected by the NAND gate 15 in a data read operation, and only one of the word line pairs is selected according to the lower address bits. That is, the two N-channel FETs 18 which are connected to the word line pair, respectively, are turned off, so that the read voltage is supplied to the word line pair through the P-channel FETs of the CMOS circuits 17. While, the other N-channel FETs 18 are turned on, so that the remaining word line pairs are coupled to ground. Thus, only one word line pair is selected in response to an applied address. The X-decoder shown in Fig. 5 is used as a read control decoder.

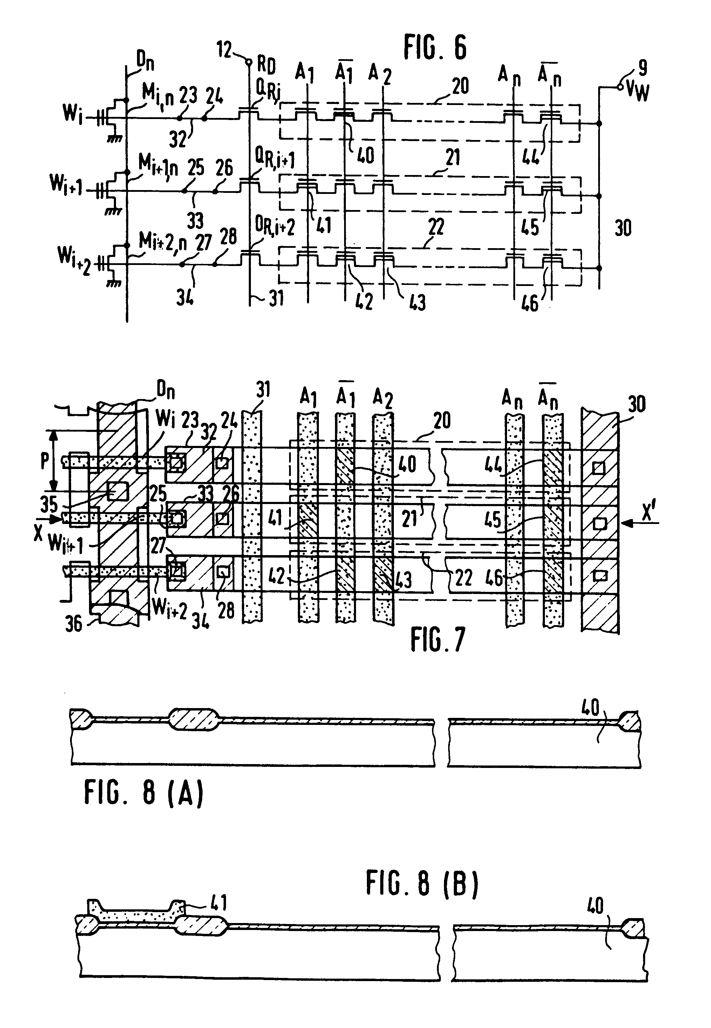

Fig. 6 shows a circuit diagram having three word lines $W_i$, $W_{i+1}$ and $W_{i+2}$ and three switching circuits 20, 21 and 22.

Fig. 7 shows a plain view of a semiconductor chip on which the circuit shown in Fig. 6 is formed. Each word line $W_i$ to $W_{i+2}$ are made of polycrystal silicon layers and are coupled to one end of each control gate $Q_{R,i}$ to $Q_{R,i+2}$ via aluminum layers 32 to 34, respectively. In Fig. 7, reference numerals 23, 25 and 27 represent contact portions of word lines and aluminum layers 32 to 34, and 24, 26 and 28 represent contact portions of aluminum layers 32 to 34 and diffusion layers of gate circuits. The other ends of gate circuits are connected to one ends of the switching circuits 20 to 22 through diffusion layers, respectively. The other ends of the switching circuits 20 to 22 are commonly connected to an aluminum layer 30 connected to the high voltage terminal $V_W$ 9. The read control signal RD is transferred through a polycrystal silicon wiring layer 31 to each gate electrode of FETs $Q_{R,i}$ to $Q_{R,i+2}$. The true signals $A_1$ to $A_n$ and the complementary signals $\overline{A}_1$ to $\overline{A}_n$ are transferred through polycrystal silicon layers to a gate electrode of each FET in the switching circuits 20 to 22. Reference numerals 40 to 46 represent D-PFET in the switching circuits. Drain layers of memory cells $M_{i,n}$ and $M_{i+1,n}$ are commonly connected to an aluminum digit wiring layer $D_n$ via a contact portion 35, while drain layers of memory cell $M_{i+2,n}$ and $M_{i+3,n}$ (not shown) are commohly connected to the aluminum digit wiring layer $D_n$ via a contact portion 36. Source layers of the memory cells $M_{i+1,n}$ and $M_{i+2,n}$ are provided in common between the word lines $W_{i+1}$ and $W_{i+2}$.

As shown in Fig. 7, each switching circuit 20 to 22 can be formed within one memory cell pitch (span) P. Therefore, a memory cell capacity on a semiconductor chip is not reduced when the switching circuits of the present invention are employed.

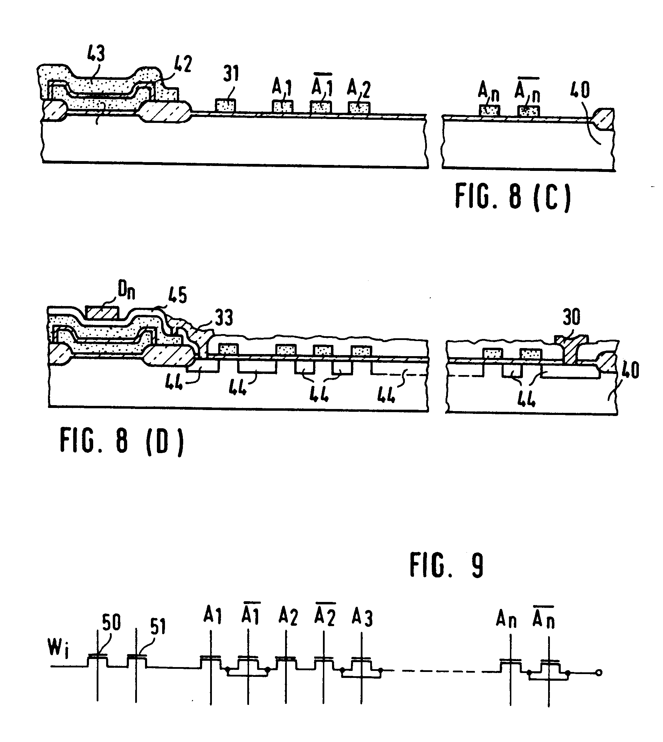

Further, the switching circuits and the gate circuits can be fabricated in the same process as the conventional memory cell manufacture process. This is shown in Figs. 8(a) to 8(d). In Fig. 8(a), isolation layers and gate insulating films are formed on an N-type semiconductor substrate 40. Thereafter, a floating gate electrodes 41 of a memory cells are formed on the gate insulating films by a first polycrystal silicon patterning (Fig. 8(b)). Next, control gate electrodes 43 are formed on the floating gate electrodes 41 via an insulating film 42 by a second polycrystal silicon patterning. At the same time, the wiring layers 31 and $A_1$ to $\overline{A}_n$ are formed on a gate film switching circuits (Fig. 8(c)). Further, P type diffusion layer 44 is formed, and digit lines $D_n$ and contact lines 30 and 33 are formed via insulating layer 45 such as a phosphosilicate glass (PSG) by an aluminum patterning (Fig. 8(d)). Thus, the switching circuits and gate circuits can be formed without adding a new process.

Fig. 9 shows a circuit diagram of a switching circuit and a gate circuit according to another embodiment of the present invention. In this embodiment, two transistors 50 and 51 are used and the switching circuit are made of all E-PFETs. However, a drain electrode and a source electrode of each E-PFET corresponding to D-PFET are shorted. Further, the transistor 50 is controlled by a read control signal and the transistor 51 is controlled by a write control signal, both signals are applied to a semiconductor circuit for controlling a data read operation and a data write operation, respectively.

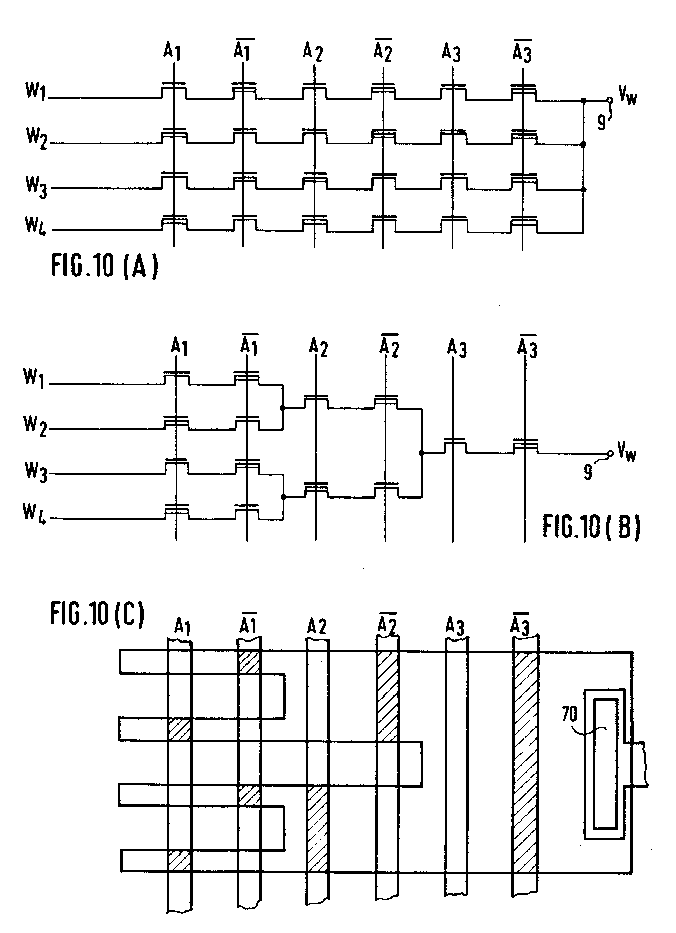

Figs. 10(a) to 10(c) show a writing circuit diagram, its equivalent circuit diagram and a plain view, respectively. In Fig. 10, three address bits and four word lines are employed. As shown in Fig. 10(b), E-PFET, and D-PFETs which continues in a vartical direction can be replaced by a single FET. Therefore, with respect to phase FETs, their channel layers are continued as shown in Fig. 10(c). As the result, a resistance of the switching circuit from the contact portion 70 to each word line can be extremely reduced. Thus, a high-speed data writing can be obtained.

## Claims

1. A semiconductor memory device comprising a plurality of row lines (W1-Wm), at least one column line (D), a plurality of memory cells (M11-Mni) disposed at intersections of said row lines and said column line, an address decoder (1) selecting one of said row lines, a terminal (9) supplied with a writing voltage (Vw), a reference terminal (ground), and a writing circuit (80), said address decoder (1) selecting in a data write operation one of said row lines by disconnecting said one row line from said reference terminal and connecting the remaining ones of said row lines to said reference terminal, characterized in that said writing circuit (80) includes a plurality of switching circuits (S1-Sm), each of which has one end coupled to said terminal (9) and the other end coupled to a corresponding one of said row lines (W1-Wm), and a control circuit (11) for turning ON one of said switching circuits (S1-Sm) that has said other end coupled to said one row line selected by said address decoder (1) to electrically connect said one row line to said terminal (9) and for turning OFF the remaining switching circuits to electrically disconnect said remaining row lines from said terminal (9), whereby a current is prevented from being flowing from said terminal (9) via said remaining row lines into said reference terminal.

**2.** A semiconductor memory device as claimed in claim 1 , **characterized** in that each of said switching circuits (S1-Sm) further has a plurality of transistors (Q1, 1-Q2n, m) connected in series between the corresponding row line and said terminal (9), and that said control circuit (11) turns OFF at least one of said transistors in all of said remaining switching circuits and turns ON all of said transistors in said one switching circuit.

**3.** A semiconductor memory device as claimed in claim 1 or 2, **characterized** by comprising means (13) inserted between each of said row lines (W1-wm) and each of said switching circuits (S1-S5) for electrically separating all of said switching circuits from said row lines in a data read operation.

**4.** A semiconductor memory device as claimed in claim 3 , in which said separating means (13) is responsive to a read control signal applied to the semiconductor memory.

**5.** A semiconductor memory as claimed in claim 2 , **characterized** in that said transistors (Q1, 1-Q2n, m) are composed of a plurality of enhancement type transistors and a plurality of depletion type transistors connected in series in a predetermined order.

**6.** A semiconductor memory as claimed in claim 2 , **characterized** in that said transistors (Q1, 1-Q2n, m) are composed of a plurality of first enhancement type transistors and a plurality of second enhancement type transistors connected in series in a predetermined order and that the drain and source electrodes of said second enhancement type transistors are short-circuited.

## Revendications

**1.** Dispositif de mémoire semi-conductrice comprenant une pluralité de lignes ($W_1$ - $W_m$), au moins une colonne (D), une pluralité de cellules de mémoire (M11 - Mni) disposées aux intersections desdites lignes et desdites colonnes, un décodeur d'adresse (1) sélectionnant l'une desdites lignes, une borne (9) recevant une tension d'écriture (Vw), une borne de référence (masse) et un circuit d'écriture (80), ledit décodeur d'adresse (1) sélectionnant, lors d'une opération d'écriture de données, l'une desdites lignes en déconnectant ladite ligne de ladite borne de référence et en connectant celles qui restent desdites lignes à ladite borne de référence, caractérisé en ce que ledit circuit d'écriture (80) comporte une pluralité de circuits de commutation (S1 - Sm), chacun d'entre eux ayant une extrémité reliée à ladite borne (9) et l'autre extrémité reliée à celle qui correspond desdites lignes (W1 - Wm), et un circuit de commande (11) pour rendre PASSANT l'un desdits circuits de commutation (S1 - Sm) dont l'autre extrémité est reliée à ladite ligne sélectionnée par ledit décodeur d'adresse (1), pour connecter électriquement ladite ligne à ladite borne (9) et pour rendre NON PASSANTS les circuits de commutation restants afin de déconnecter électriquement lesdites lignes restantes de ladite borne (9), se qui empêche tout courant de passer entre ladite borne (9), par l'intermédiaire desdites lignes restantes, et ladite borne de référence.

**2.** Dispositif de mémoire semi-conductrice selon la revendication 1, caractérisé en ce que chacun des circuits de commutation (S1 - Sm) comporte en outre une pluralité de transistors (Q1, 1-Q2n, m) connectés en série entre la ligne correspondante et ladite borne (9) et ce que ledit circuit de commande (11) rend NON PASSANT au moins l'un desdits transistors de la totalité desdits circuits de commutation restants et rend PASSANTS tous lesdits transistors se trouvant dans ledit circuit de commutation.

**3.** Dispositif de mémoire semi-conductrice selon la revendication 1 ou 2, caractérisé par le fait qu'il comprend un moyen (13) inséré entre chacune desdites lignes (W1 - Wm) et chacun desdits circuits de commutation (S1 - S5) pour séparer électriquement la totalité desdits circuits de commutation desdites lignes, lors d'une opération de lecture de données.

4.  Dispositif de mémoire semi-conductrice selon la revendication 3, dans lequel ledit moyen de séparation (13) est sensible à un signal de commande de lecture appliqué à la mémoire semi-conductrice.

5.  Mémoire semi-conductrice selon la revendication 2, caractérisée en ce que lesdits transistors (Q1, 1-Q2n, m) sont composés d'une pluralité de transistors à enrichissement et d'une pluralité de transistors à déplétion connectés en série dans un ordre prédéterminé.

6.  Mémoire semi-conductrice selon la revendication 2, caractérisée en ce que lesdits transistors (Q1, 1-Q2n, m) se composent d'une pluralité de premiers transistors à enrichissement et d'une pluralité de seconds transistors à déplétion connectés en série dans un ordre prédéterminé, et en ce que les électrodes de drain et de source desdits transistors à enrichissement sont court-circuitées.

**Patentansprüche**

1.  Halbleiterspeichervorrichtung mit einer Anzahl Zeilenleitungen (W1-Wm), zumindest einer Spaltenleitung (D), einer Anzahl Speicherzellen (M11-Mni), die an Schnittpunkten der Zeilenleitungen und der Spaltenleitung angeordnet sind, einem Adressendekoder (1) zur Auswahl einer der Zeilenleitungen, einem Anschluß (9), der mit einer Schreibspannung (Vb) versorgt wird, einem Bezugsanschluß (ground) und einer Schreibschaltung (80), wobei der Adressendekoder (1) in einem Datenschreibbetrieb eine der Zeilenleitungen durch Trennen der einen Zeilenleitung vom Bezugsanschluß und durch Verbinden der verbleibenden Zeilenleitungen mit dem Bezugsanschluß auswählt,
    dadurch **gekennzeichnet,** daß die Schreibschaltung (80) eine Anzahl von Schalterschaltungen (S1-Sm) aufweist, von denen jede ein mit dem Anschluß (9) verbundenes Ende und ein anderes, mit einer entsprechenden der Zeilenleitungen (W1-Wm) verbundenes Ende aufweist, und eine Steuerschaltung (11) zum Einschalten einer der Schalterschaltungen, deren anderes Ende mit der vom Adressendekoder (1) ausgewählten einen Zeilenleitung verbunden ist, um die eine Zeilenleitung mit dem Anschluß (9) elektrisch zu verbinden, und zum Ausschalten der verbleibenden Schalterschaltungen, um die verbleibenden Zeilenleitungen von dem Anschluß (9) zu trennen, wodurch ein Stromfluß von dem Anschluß (9) über die verbleibenden Zeilenleitungen zu dem Bezugsanschluß verhindert wird.

2.  Halbleiterspeichervorrichtung nach Anspruch 1,
    dadurch **gekennzeichnet,** daß jede der Schalterschaltungen (S1-Sm), ferner eine Anzahl von Transistoren (Q1, 1-Q2m) aufweist, die in Reihe zwischen die entsprechende Zeilenleitung und den Anschluß (9) geschaltet sind, und daß die Steuerschaltung (11) zumindest einen der Transistoren in allen verbleibenden Schalterschaltungen ausschaltet und alle Transistoren in der einen Schalterschaltung einschaltet.

3.  Halbleiterspeichervorrichtung nach Anspruch 1 oder 2,
    **gekennzeichnet** durch eine Einrichtung (13), die zwischen jede der Zeilenleitungen (W1-Wm) und jede der Schalterschaltungen (S1-S5) eingefügt ist zum elektrischen Trennen all der Schalterschaltungen von den Zeilenleitungen in einem Datenlesebetrieb.

4.  Halbleiterspeichervorrichtung nach Anspruch 3, wobei die Trenneinrichtung (13) auf ein dem Halbleiterspeicher zugeführtes Lese-Steuersignal anspricht.

5.  Halbleiterspeicher nach Anspruch 2,
    dadurch **gekennzeichnet,** daß die Transistoren (Q1, 1-Q2nm) aus einer Anzahl von Anreicherungstransistoren und einer Anzahl von Verarmungstransistoren, die in einer vorgegebenen Reihenfolge in Reihe geschaltet sind, zusammengesetzt sind.

6.  Halbleiterspeicher nach Anspruch 2,
    dadurch **gekennzeichnet,** daß die Transistoren (Q1, 1-Q2nm) aus einer Anzahl von ersten Anreicherungstransistoren und einer Anzahl von zweiten Anreicherungstransistoren zusammengesetzt sind, die in einer vorgegebenen Reihenfolge in Reihe geschaltet sind, und daß die Drain- und Source-Elektroden der zweiten Anreicherungstransistoren kurzgeschlossen sind.

7

FIG.1 (PRIOR ART)

FIG.2

FIG. 3

FIG. 4

FIG. 5

FIG. 6

FIG. 7

FIG. 8 (A)

FIG. 8 (B)

FIG. 8 (C)

FIG. 8 (D)

FIG. 9

FIG.10 (A)

FIG.10 ( B)

FIG.10 (C)